(19) Europäisches Patentamt
European Patent Office
Office européen des brevets

(11) EP 1 837 903 B1

(12) # EUROPEAN PATENT SPECIFICATION

(45) Date of publication and mention of the grant of the patent:
**01.05.2019 Bulletin 2019/18**

(51) Int Cl.:
***H01L 21/321*** *(2006.01)* ***C09G 1/02*** *(2006.01)*
***C09K 3/14*** *(2006.01)*

(21) Application number: **07006060.3**

(22) Date of filing: **23.03.2007**

(54) **Metal polishing slurry and use of said slurry**

Metallpoliermittel und Verwendung dieses Metallpoliermittels

Suspension de polissage pour métal et utilisation de cette suspension

(84) Designated Contracting States:
**BE DE GB**

(30) Priority: **23.03.2006 JP 2006081002**

(43) Date of publication of application:
**26.09.2007 Bulletin 2007/39**

(73) Proprietor: **FUJIFILM Corporation**
**Minato-ku**
**Tokyo (JP)**

(72) Inventor: **Yamashita, Katsuhiro**
**Haibara-gun**
**Shizuoka (JP)**

(74) Representative: **Hoffmann Eitle**
**Patent- und Rechtsanwälte PartmbB**
**Arabellastraße 30**
**81925 München (DE)**

(56) References cited:
**EP-A- 1 548 075** **EP-A- 1 612 249**
**JP-A- 6 199 515** **JP-A- 63 123 807**
**US-A- 3 948 703** **US-A1- 2002 020 833**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 1 837 903 B1

## Description

### BACKGROUND OF THE INVENTION

The present invention relates to the manufacture of semiconductor devices. More particularly, the invention relates to a metal polishing slurry for use in the formation of interconnections in semiconductor devices, and to a polishing method which employs such a slurry.

In the development of semiconductor devices such as semiconductor integrated circuits (referred to below as "LSI devices"), the trend toward smaller sizes and higher processing speeds has created a need in recent years for higher density and higher integration by the adoption of smaller design rules and multilayer constructions. Various techniques are being used to this end, including chemical mechanical polishing (CMP) wherein an insulating thin film (e.g., $SiO_2$) and a metal thin film used to form interconnections are polished to planarize the substrate and remove surplus metal thin film during formation of the interconnections. CMP is an essential technique for carrying out, for example, the surface planarization of a film to be processed (e.g., an interlayer dielectric), plug formation and buried metal interconnect formation, and thus is used to carry out substrate planarization and to remove surplus metal thin film during the formation of interconnections. This technique is described in, for example, US 4944836.

CMP generally involves attaching a polishing pad onto a circular platen, impregnating the surface of the polishing pad with a polishing slurry, pressing the right side of a substrate (wafer) against the pad, and rotating both the platen and the substrate while applying a predetermined pressure (polishing pressure) from the back side of the substrate so as to planarize the right side of the substrate by the mechanical friction that arises.

The metal polishing slurry used in CMP typically includes fine abrasive particles (e.g., alumina, silica) and an oxidizer (e.g., hydrogen peroxide, persulfuric acid). It is believed that polishing takes place with oxidization of the metal surface by the oxidizer and removal of the resulting oxide film by the abrasive.

The wiring metals that have commonly been used in interconnect structures up until now are tungsten and aluminum. However, to achieve even higher performance levels, LSIs that use copper, which has a lower wiring resistance than tungsten and aluminum, have been developed. Known methods for wiring with copper include the damascene process described in JP 2-278822 A. Widespread use is now also made of the dual damascene process, in which contact holes and wiring trenches are formed in an interlayer dielectric concurrently with each other, and then both the holes and the trenches are filled with metal. High-purity copper targets of at least five-nine purity have been shipped as the target material for the copper wiring. However, with the move in recent years toward wiring of a smaller design rule aimed at achieving even higher circuit densities, a need has arisen for improvements in the electrical conductivity and electronic properties of copper interconnections. To this end, studies have begun to be carried out on the use of copper alloys obtained by adding very small amounts of a third constituent such as silver to the high-purity copper.

Metal polishing slurries are described also in EP 1 612 249 A, EP 1 548 075 A and US 2002/020833 A.

### SUMMARY OF THE INVENTION

Under the circumstances, there exists a desire for a highspeed metal polishing means which is able to achieve a high throughput without contaminating such elaborate high-purity materials. In polishing copper metal, because copper is a particularly soft metal, there is a tendency of certain undesirable phenomena to occur. These include dishing, in which the polished metal surface, instead of being made planar, is more deeply polished only at the center, forming a dish-like hollow; erosion, where the dielectric between metal interconnections is polished more than necessary and, in addition, dish-like depressions are formed at a plurality of wiring metal surfaces; and scratching. Hence the desire for polishing technology of ever greater precision.

Recently, to improve productivity, wafer diameters during LSI fabrication have become larger, with diameters of 200 mm or more being currently the norm. LSI fabrication at wafer diameters of 300 mm or more has even begun. As the wafer size increases, differences in polishing rate tend to arise between the center and the edge of the wafer. Hence requirements for polishing uniformity across the wafer have become more and more exacting.

An example of a known process for chemically polishing copper and copper alloys, that is, a process which does not include a mechanical polishing means, is the method described in JP 49-122432 A. However, in contrast with CMP in which chemical and mechanical polishing is performed selectively on the metal film at raised features, due to the occurrence of dishing and the like at low features, planarity is a major challenge in chemical polishing processes that rely entirely on a chemical dissolving action. Corrosion inhibitors such as benzotriazole are often used to keep excessive chemical dissolution from occurring, although this has had the undesirable effect of slowing the polishing rate.

It is therefore an object of the present invention to provide a metal polishing slurry for use in chemical mechanical polishing (CMP) which is able to polish metals including copper at a high rate and causes minimal dishing.

Accordingly, the invention provides the following metal polishing slurries, and the following semiconductor integrated circuit substrate polished with such a slurry.

(1) A metal polishing slurry for use in chemical mechanical metal polishing during semiconductor device fabrication, containing at least one compound of formula (A) below and at least one compound of formula (B) or formula (C) below:

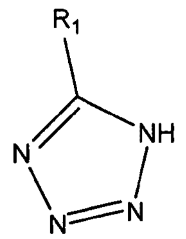

(A)

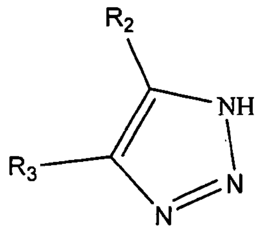

(B)

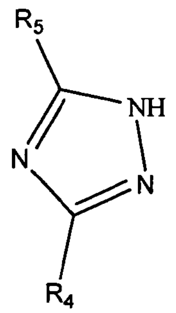

(C)

[wherein $R_1$, $R_2$, $R_3$, $R_4$ and $R_5$ are each independently hydrogen, methyl, ethyl, phenyl, amino, sulfo, carboxy, aminomethyl, carboxymethyl, sulfomethyl, o-aminophenyl, m-aminophenyl, p-aminophenyl, o-carboxyphenyl, m-carboxyphenyl, p-carboxyphenyl, o-sulfophenyl, m-sulfophenyl or p-sulfophenyl] which further comprises colloidal silica, wherein at least some of silicon atoms at the surface of the colloidal silica are substituted with aluminum atoms, and which further contains an oxidizer and water.

(2) The metal polishing slurry of (1) above, wherein the colloidal silica has a primary particle size of 10 to 60 nm.

(3) The metal polishing slurry of any one of (1) to (2) above which has a pH of 2 to 7.

(4) The metal polishing slurry of any one of (1) to (3) above, wherein the concentration of the colloidal silica in the metal polishing slurry is 0.001 to 0.5 wt%.

(5) The metal polishing slurry of any one of (1) to (4) above which contains a compound having at least one carboxy group and at least one amino group in its molecule.

(6) The metal polishing slurry of (5) above, wherein at least one amino group in the compound having at least one carboxy group and at least one amino group in its molecule is a secondary or tertiary amino group.

(7) The metal polishing slurry of any one of (1) to (6) above which contains a quaternary alkylammonium compound.

(8) Use of the metal polishing slurry of any one of (1) to (7) above for chemical mechanical metal polishing in semiconductor integrated circuit substrate manufacturing.

DETAILED DESCRIPTION OF THE INVENTION

The invention is described more fully below.

The metal polishing slurry of the invention contains at least one compound of formula (A).

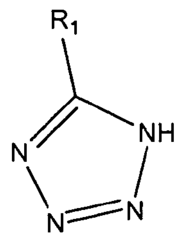

(A)

In the formula, $R_1$ is hydrogen, methyl, ethyl, phenyl, amino, sulfo, carboxy, aminomethyl, carboxymethyl, sulfomethyl, o-aminophenyl, m-aminophenyl, p-aminophenyl, o-carboxyphenyl, m-carboxyphenyl, p-carboxyphenyl, o-sulfophenyl, m-sulfophenyl or p-sulfophenyl.

Of these, hydrogen, amino, aminomethyl, carboxymethyl or sulfomethyl is preferred. Carboxymethyl or sulfomethyl is more preferred.

The metal polishing slurry of the invention contains, together with the compound of formula (A), at least one compound of formula (B) or formula (C).

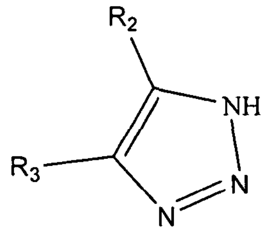

(B)

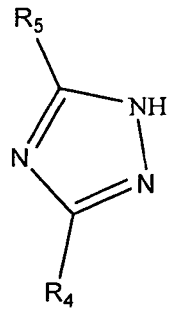

(C)

In these formulas, $R_2$, $R_3$, $R_4$ and $R_5$ are each independently hydrogen, methyl, ethyl, phenyl, amino, sulfo, carboxy, aminomethyl, carboxymethyl, sulfomethyl, o-aminophenyl, m-aminophenyl, p-aminophenyl, o-carboxyphenyl, m-carboxyphenyl, p-carboxyphenyl, o-sulfophenyl, m-sulfophenyl or p-sulfophenyl.

Of these, hydrogen, carboxy, amino, sulfo, carboxymethyl, aminomethyl, methyl or phenyl is preferred. Carboxy or carboxymethyl is more preferred.

Illustrative, non-limiting examples of compounds having formula (A) (A-1 to A-12), formula (B) (B-1 to B-9) and formula (C) (C-1 to C-11) are given below. These compounds may be used singly or as combinations of two or more thereof.

A-1

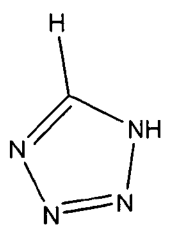

A-2

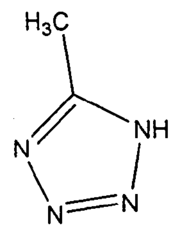

A-3

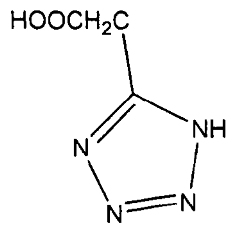

A-4

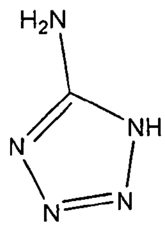

A-5

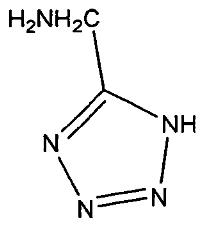

A-6

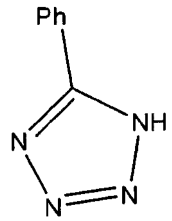

A-7

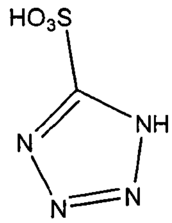

A-8

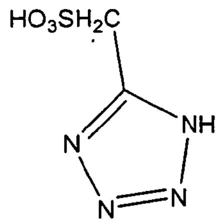

A-9

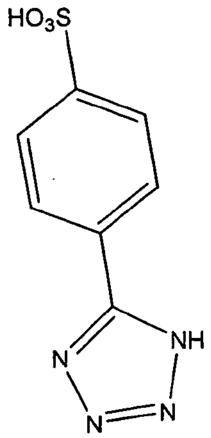

A-10

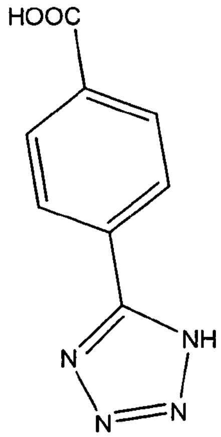

A-11

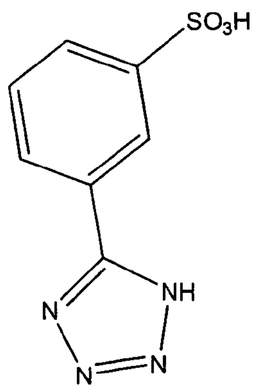

A-12

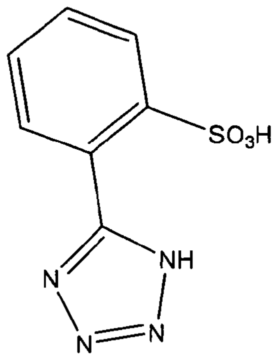

B-1

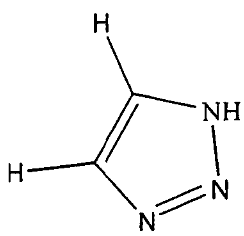

B-2

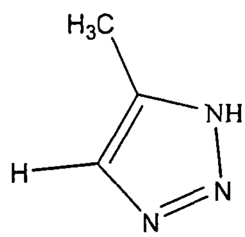

B-3

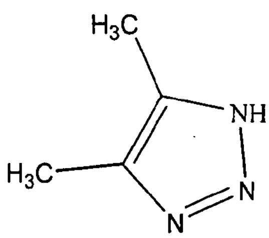

B-4

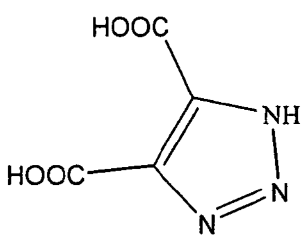

B-5

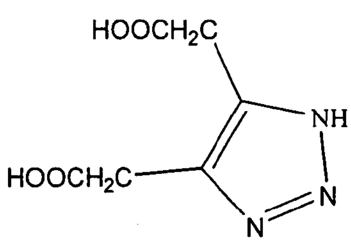

B-6

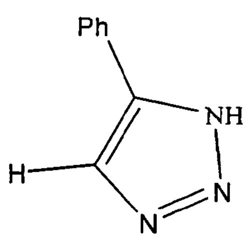

B-7

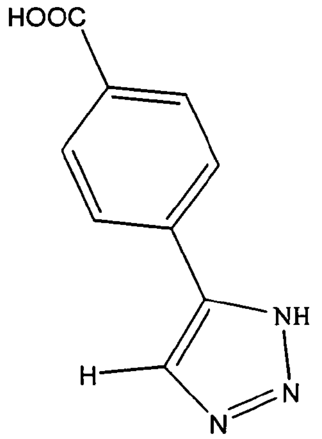

B-8

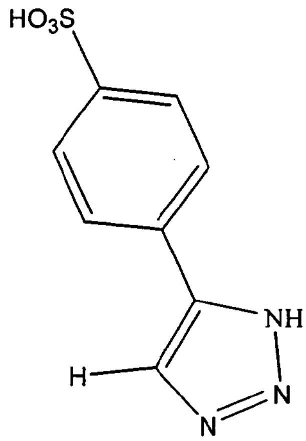

B-9

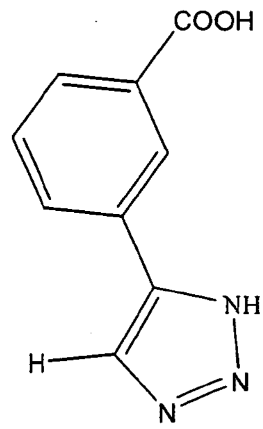

C-1

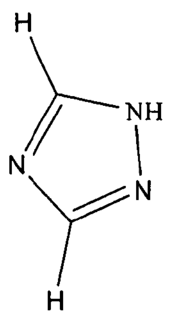

C-2

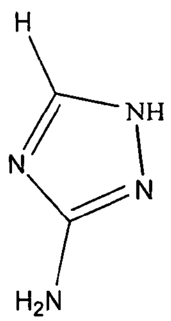

C-3

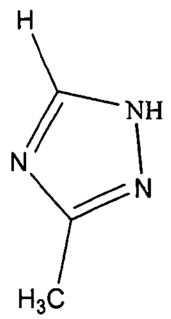

C-4

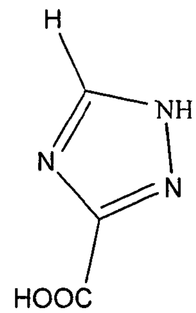

C-5

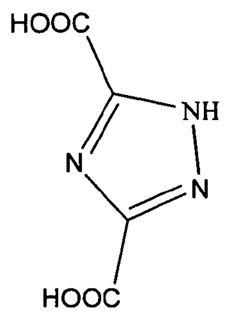

C-6

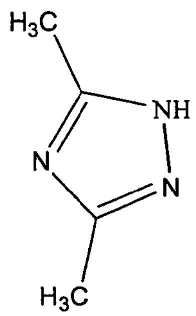

C-7

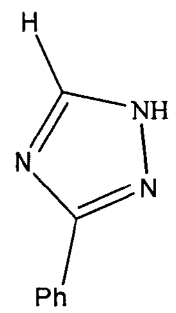

C-8

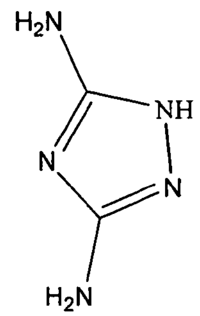

C-9

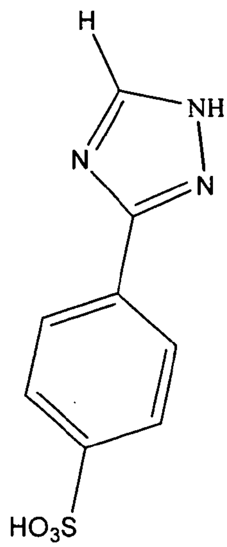

C-10

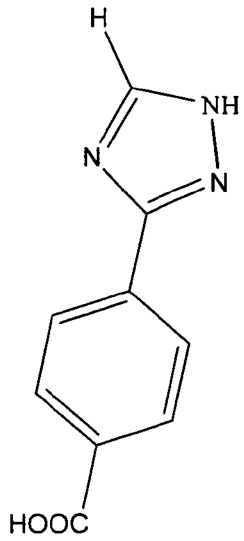

C-11

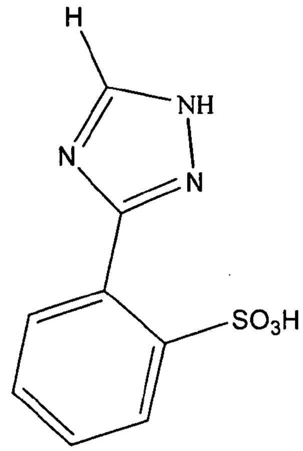

The compound of formula (A) is added in an amount of preferably 0.0001 to 1 wt%, and more preferably 0.001 to 0.1 wt%.

The compound of formula (B) or (C) is added in an amount of preferably 0.0001 to 1 wt%, and more preferably 0.001 to 0.1 wt%.

With the addition of only a compound of formula (A), the dishing minimizing effect is small, but when a compound of general (B) or (C) is used in combination with a compound of formula (A), the extent of dishing can be made very small. The present invention has a particularly large effect when the above compounds are combined in this way.

It is necessary for at least part of the particulate abrasive used in the metal polishing slurry of the invention to be colloidal silica in which at least some of the silicon atoms at the surface of the colloidal silica are substituted with aluminum atoms. The abrasive is more preferably a colloidal silica which has been obtained by the hydrolysis of alkoxysilane and contains no impurities such as alkali metals within the particles. A method suitable for producing the abrasive may involve adding an aluminate compound such as sodium aluminate to a dispersion of colloidal silica. Such methods are disclosed in, for example, JP 3463328 B and JP 63-123807 A. Use can also be made of, for example, methods that involve the addition of an aluminum alkoxide. The colloidal silica produced by the former methods has an excellent dispersibility even under acidic conditions because the aluminosilicate sites formed by the reaction of tetracoordinate aluminate ions with silanol groups at the surface of the colloidal silica immobilize negative charges, conferring a large negative zeta potential on the particles. Therefore, it is important for the colloidal silica produced by the former methods to exist in a state where one aluminum atom is coordinated with four oxygen atoms. Such colloidal silica clearly differs in structure from abrasive particles coated with alumina in which one aluminum atom is coordinated generally with six oxygen atoms.

The amount of silicon atoms at the surface of the colloidal silica that are substituted with aluminum atoms, expressed as the colloidal silica surface atom substitution ratio (number of aluminum atoms introduced/number of surface silicon atom sites), is preferably at least 0.001% but not more than 50%, more preferably at least 0.01% but not more than 25%, and most preferably at least 0.1% but not more than 10%. The polishing slurry of the invention has a pH of preferably 2 to 7. Of the abrasive contained in the polishing slurry of the invention, the weight ratio of colloidal silica in which surface silicon atoms have been substituted with aluminum atoms is preferably at least 50%, and most preferably at least 80%. The content of colloidal silica in which surface silicon atoms have been substituted with aluminum atoms, based on the overall polishing slurry, is preferably at least 0.001 wt% but not more than 5 wt%. Within this range, the dispersibility is excellent. The content of this colloidal silica is more preferably at least 0.01 wt% but not more than 5 wt%, even more preferably at least 0.01 wt% but not more than 0.5 wt%, and most preferably at least 0.05 wt % but not more than 0.2 wt%. The size (volume equivalent diameter) of the primary particles of colloidal silica in which surface silicon atoms have been substituted with aluminum atoms is preferably from 3 nm to 200 nm. Within this range, the dispersibility is excellent. The size of these primary particles is more preferably from 5 nm to 100 nm, and even more preferably from 10 nm to 60 nm.

Abrasive

Illustrative examples of the abrasive which may be contained in addition to the colloidal silica in which surface silicon atoms are substituted with aluminum atoms include precipitated silica, fumed silica, colloidal silica, synthetic silica, ceria, alumina, titania, zirconia, germania, manganese oxide, silicon carbide, polystyrene, polyacrylic and polyethylene terephthalate. Of these, fumed silica, colloidal silica, ceria, alumina and titania are preferred, and colloidal silica is especially preferred. The size of the abrasive particles other than the colloidal silica in which surface silicon atoms are substituted with aluminum atoms is preferably at least equivalent to but not more than twice the size of the colloidal silica in which surface silicon atoms are substituted with aluminum atoms.

The abrasive content, based on the total weight of the metal polishing slurry at the time of use (working slurry), is preferably in a range of 0.01 to 20 wt%, and more preferably in a range of 0.05 to 5 wt%.

Known art similar to the colloidal silica in the present invention includes, for example, the composite abrasive particles described in JP 2005-159269 A which are composed of base particles coated with alumina. Although a method for producing the alumina-coated base particles is not described, US 3007878 discloses a technique in which an aqueous solution of an aluminum salt is added to silica sol to coat the surfaces of the colloid particles with alumina and positively charge the particle surfaces in order to stabilize the dispersion of the colloid particles. That is, alumina-coated colloidal silica is positively charged. Because the positively charged abrasive particles have a zero potential point that is close to neutrality, they tend to agglomerate during pH adjustment. Hence, such particles clearly differ from the colloidal silica used in the present invention, in which at least some of the silicon atoms at the surface of the colloidal silica are substituted with aluminum atoms.

JP 2003-197573 A discloses a colloidal silica for polishing, in which some or all of the surface of the colloidal silica produced by a method which removes the alkali from an aqueous solution of an alkali silicate is coated with aluminum. However, in the case of colloidal silica produced by a method which removes the alkali from an aqueous solution of an alkali silicate, alkali metal remaining inside the particles gradually leaches out, which has an adverse influence on the polishing performance. In the present invention, it is preferable to use colloidal silica obtained from alkoxysilane as the starting material, which differs from the art of JP 2003-197573 A.

Quaternary Alkylammonium Compound

The metal polishing slurry of the present invention preferably contains a quaternary alkylammonium compound. Illustrative examples of quaternary alkylammonium compounds include tetramethylammonium hydroxide, tetramethylammonium nitrate, tetraethylammonium hydroxide, tetraethylammonium nitrate and stearinetrimethylammonium nitrate. Tetramethylammonium hydroxide is especially preferred. The content of the quaternary alkylammonium compound is preferably at least 0.01 wt% but not more than 20 wt%, more preferably at least 0.1 wt% but not more than 5 wt%, and most preferably at least 0.5 wt% but not more than 2 wt%.

Water-Soluble Polymer

The metal polishing slurry of the invention preferably contains a water-soluble polymer. The water-soluble polymer serves to lower the angle of contact with the surface to be polished, and has the effect of promoting a uniform polishing. Examples of the water-soluble polymer which is suitable to use include ammonium polyacrylate, polyvinyl alcohol, succinamide, polyvinylpyrrolidone, polyethylene glycol, and polyoxyethylene-polyoxypropylene block polymers. The total amount of water-soluble polymer or polymers added per liter of the metal polishing slurry when used in polishing is preferably from 0.001 to 10 g, more preferably from 0.01 to 5 g, and most preferably from 0.1 to 3 g. It is preferable for the amount of water-soluble polymer added to be at least 0.001 g so as to achieve a sufficient effect, but not more than 10 g to avoid a decrease in the CMP rate. The weight-average molecular weight of these water-soluble polymers is preferably from 500 to 100,000, and most preferably from 2,000 to 50,000.

Oxidizer

The metal polishing slurry of the invention contains an oxidizer. The oxidizer is a compound which is capable of oxidizing the metal that is to be polished.

Illustrative examples of oxidizers include hydrogen peroxide, peroxides, nitric acid, nitrates, iodates, periodates, hypochlorous acid, hypochlorites, chlorites, chlorates, perchlorates, persulfates, bichromates, permanganates, ozonated water, silver (II) salts, and iron (III) salts.

Preferred iron (III) salts include inorganic iron (III) salts such as iron (III) nitrate, iron (III) chloride, iron (III) sulfate and iron (III) bromide, and also organic complex salts of iron (III).

When an organic complex salt of iron (III) is used, illustrative examples of the complex-forming compound

making up the complex salt of iron (III) include acetic acid, citric acid, oxalic acid, salicylic acid, diethyldithiocarbamic acid, succinic acid, tartaric acid, glycolic acid, glycine, alanine, aspartic acid, thioglycolic acid, ethylenediamine, trimethylenediamine, diethylene glycol, triethylene glycol, 1,2-ethanedithiol, malonic acid, glutaric acid, 3-hydroxybutyric acid, propionic acid, phthalic acid, isophthalic acid, 3-hydroxysalicylic acid, 3,5-dihydroxysalicylic acid, gallic acid, benzoic acid and maleic acid, as well as salts thereof, and also aminopolycarboxylic acids and salts thereof.

Illustrative examples of aminopolycarboxylic acids and their salts include ethylenediamine-N,N,N',N'-tetraacetic acid, diethylenetriaminepentaacetic acid, 1,3-diaminopropane-N,N,N',N'-tetraacetic acid, 1,2-diaminopropane-N,N,N',N'-tetraacetic acid, ethylenediamine-N,N'-disuccinic acid (racemic mixture), ethylenediaminedisuccinic acid (SS form), N-(2-carboxylate ethyl)-L-aspartic acid, N-(carboxymethyl)-L-aspartic acid, β-alaninediacetic acid, methyliminodiacetic acid, nitrilotriacetic acid, cyclohexanediaminetetraacetic acid, iminodiacetic acid, glycol ether diamine tetraacetic acid, ethylenediamine-N,N'-diacetic acid, ethylenediamine-ortho-hydroxyphenylacetic acid, N,N-bis(2-hydroxybenzyl)ethylenediamine-N,N-diacetic acid, and salts thereof. The salt is preferably an alkali metal salt or an ammonium salt. An ammonium salt is especially preferred.

Of the above, hydrogen peroxide, iodates, hypochlorites, chlorates, persulfates, and organic complex salts of iron (III) are preferred. When an organic complex salt of iron (III) is used, preferred complex-forming compounds include citric acid, tartaric acid and aminopolycarboxylic acids (specifically, ethylenediamine-N,N,N',N'-tetraacetic acid, diethylenetriaminepentaacetic acid, 1,3-diaminopropane-N,N,N',N'-tetraacetic acid, ethylenediamine-N,N'-disuccinic acid (racemic mixture), ethylenediaminedisuccinic acid (SS form), N-(2-carboxylate ethyl)-L-aspartic acid, N-(carboxymethyl)-L-aspartic acid, β-alaninediacetic acid, methyliminodiacetic acid, nitrilotriacetic acid, iminodiacetic acid).

Of the above oxidizers, hydrogen peroxide is the most preferred.

The amount of oxidizer added is preferably from 0.003 to 8 mol, more preferably from 0.03 to 6 mol, and most preferably from 0.1 to 4 mol, per liter of the metal polishing slurry at the time of use in polishing. The amount of oxidizer added is preferably at least 0.003 mol/L to ensure sufficient oxidation of the metal and a high CMP rate, but is preferably not more than 8 mol/L to prevent roughening of the polished surface.

Carboxy Group and Amino Group-Bearing Compound

The metal polishing slurry of the invention preferably contains a compound having at least one carboxy group and at least one amino group in its molecule. It is preferable for at least one amino group in the compound to be a secondary or tertiary amino group. Preferred examples of such compounds include α-amino acids such as glycine, alanine, valine and glutamic acid; β-amino acids such as β-alanine; iminodiacetic acid, hydroxyethyliminodiacetic acid, hydroxyethylglycine, dihydroxyethylglycine, glycylglycine, and N-methylglycine. It is more preferred that two or more compounds each having at least one carboxy group and at least one amino group in the molecule are contained in the polishing slurry, and the use of a compound having only one carboxy group in the molecule together with a compound having two or more carboxy groups in the molecule is especially preferred. The compound having at least one carboxy group and at least one amino group in the molecule is added in an amount of preferably at least 0.1 wt% but not more than 5 wt%, and more preferably at least 0.5 wt% but not more than 2 wt%.

Amino Group and Sulfo Group-Bearing Compound

The metal polishing slurry of the invention preferably contains a compound having at least one amino group and at least one sulfo group in its molecule. Examples of such compounds include aminomethanesulfonic acid and taurine. Taurine is preferred. The compound having at least one amino group and at least one sulfo group in the molecule is added in an amount of preferably at least 0.1 wt% but not more than 10 wt%, and more preferably at least 1 wt% but not more than 5 wt%.

Organic Acid

The metal polishing slurry of the invention may also include an organic acid. The organic acid promotes oxidation, or acts as a pH adjustor or buffering agent. The organic acid referred to here is a compound having a different structure than the oxidizer for oxidizing the metal, and does not encompass acids which function as the above-described oxidizer.

"Organic acid" refers to an organic compound which generates an acid, and is preferably a compound having at least one carboxy group. It is desirable for the organic acid to be a compound which is water-soluble. Amino acids may also be included.

Organic acids selected from the following are even more suitable: formic acid, acetic acid, propionic acid, butyric acid, valeric acid, 2-methylbutyric acid, n-hexanoic acid, 3,3-dimethylbutyric acid, 2-ethylbutyric acid, 4-methylpentanoic acid, n-heptanoic acid, 2-methylhexanoic acid, n-octanoic acid, 2-ethylhexanoic acid, benzoic acid, alkylsulfonic acid, dodecylbenzenesulfonic acid, glycolic acid, salicylic acid, glyceric acid, oxalic acid, malonic acid, succinic acid, glutaric

acid, adipic acid, pimelic acid, maleic acid, phthalic acid, malic acid, tartaric acid, citric acid, lactic acid, as well as ammonium salts and alkali metal salts thereof.

The amount of organic acid added is preferably from 0.0005 to 0.5 mol, more preferably from 0.005 to 0.3 mol, and most preferably from 0.01 to 0.1 mol, per liter of the metal polishing slurry at the time of use in polishing (working slurry). That is, to suppress etching, the amount of acid added is preferably not more than 0.5 mol/L, but is preferably at least 0.0005 mol/L to achieve a sufficient effect.

Solvent and Dispersant

The metal polishing slurry of the invention additionally contains, as a solvent or dispersant, water and/or an aqueous solution. When the metal polishing slurry of the invention is diluted with water, an aqueous solution or the like at the time of use in polishing, the dilution factor is generally 1 to 20 based on the volume.

The following ingredients may also be added to the metal polishing slurry of the invention.

Inorganic Acid

An inorganic acid may additionally be contained in the metal polishing slurry of the invention for such purposes as of promoting oxidation, adjusting the pH, and achieving buffering effects.

Illustrative, non-limiting examples of the inorganic acid include sulfuric acid, nitric acid, boric acid and phosphoric acid. Of these, phosphoric acid is preferred.

The content of the inorganic acid is preferably from 0.0005 to 0.5 mol per liter of the metal polishing slurry at the time of use in polishing (working slurry). That is, to suppress etching, the content of the inorganic acid is preferably not more than 0.5 mol/L, but is preferably at least 0.0005 mol/L to achieve a sufficient effect.

For an even better balance of these properties, the content of the above inorganic acid is more preferably from 0.005 to 0.3 mol, and even more preferably from 0.01 to 0.1 mol, per liter of the metal polishing slurry at the time of use in polishing (working slurry).

Chelating Agent

It is advantageous for the metal polishing slurry of the invention to also contain a chelating agent (i.e., a water softener) so as to reduce the adverse influence of polyvalent metal ions that get mixed into the slurry.

The chelating agent is a general-purpose water softener which prevents the precipitation of calcium and magnesium, or an analogous compound. Illustrative examples include nitrilotriacetic acid, diethylenetriaminepentaacetic acid, ethylenediaminetetraacetic acid, N,N,N-trimethylenephosphonic acid, ethylenediamine-N,N,N',N'-tetramethylenesulfonic acid, trans-cyclohexanediaminetetraacetic acid, 1,2-diaminopropanetetraacetic acid, glycol ether diamine tetraacetic acid, ethylenediamine-ortho-hydroxyphenylacetic acid, ethylenediaminedisuccinic acid (SS form), N-(2-carboxylate ethyl)-L-aspartic acid, β-alaninediacetic acid, 2-phosphonobutane-1,2,4-tricarboxylic acid, 1-hydroxyethylidene-1,1-diphosphonic acid, N,N'-bis(2-hydroxybenzyl)ethylenediamine-N,N'-diacetic acid and 1,2-dihydroxybenzene-4,6-disulfonic acid. These may be used singly or as combinations of two or more thereof.

The content of the above chelating agent should be an amount sufficient to sequester metal ions such as polyvalent metal ions that get mixed into the slurry. For example, from 0.0003 to 0.07 mol per liter of the metal polishing slurry at the time of use in polishing (working slurry) is preferred.

Alkaline Agent and Buffering Agent

If necessary, the metal polishing slurry of the invention may also contain an alkaline agent to adjust the pH. Moreover, a buffering agent may additionally be contained to inhibit fluctuations in the pH.

Illustrative examples of the alkaline agent and the buffering agent include nonmetallic alkaline agents such as ammonium hydroxide, organic ammonium hydroxides (e.g., tetramethylammonium hydroxide) and alkanolamines (e.g., diethanolamine, triethanolamine, triisopropanolamine); alkali metal hydroxides such as sodium hydroxide, potassium hydroxide and lithium hydroxide; as well as carbonates, phosphates, borates, tetraborates, hydroxybenzoates, glycyl salts, N,N-dimethylglycine salts, leucine salts, norleucine salts, guanine salts, 3,4-dihydroxyphenylalanine salts, alanine salts, aminobutyrates, 2-amino-2-methyl-1,3-propanediol salts, valine salts, proline salts, trishydroxyaminomethane salts and lysine salts.

Specific examples of the above include sodium carbonate, potassium carbonate, sodium bicarbonate, potassium bicarbonate, trisodium phosphate, tripotassium phosphate, disodium phosphate, dipotassium phosphate, sodium borate, potassium borate, sodium tetraborate (borax), potassium tetraborate, sodium o-hydroxybenzoate (sodium salicylate), potassium o-hydroxybenzoate, sodium 5-sulfo-2-hydroxybenzoate (sodium 5-sulfosalicylate), potassium 5-sulfo-2-hydroxybenozate (potassium 5-sulfosalicylate) and ammonium hydroxide.

These may be used singly or as combinations of two or more thereof.

Of the above, ammonium hydroxide, potassium hydroxide, lithium hydroxide and tetramethylammonium hydroxide are preferred.

The content of the alkaline agent and the buffering agent should be an amount that keeps the pH in the preferred range. This content is preferably from 0.0001 to 1.0 mol, and more preferably from 0.003 to 0.5 mol, per liter of the metal polishing slurry at the time of use in polishing (working slurry).

The metal polishing slurry at the time of use in polishing (working slurry) has a pH of preferably 2 to 14, more preferably 3 to 12, and even more preferably 3.5 to 8. At a pH in this range, the metal polishing slurry of the invention exhibits particularly outstanding effects.

An acid may be added to adjust the pH to the desired value. Acids that may be used for this purpose include sulfuric acid, nitric acid, boric acid, phosphoric acid and carbonic acid. Of these, phosphoric acid, nitric acid and sulfuric acid are preferred.

The types and contents of compounds contained in the metal polishing slurry of the invention, as well as the pH of the slurry, may be set as appropriate in accordance with such considerations as the adsorptivity to and reactivity with the polishing surface, the solubility of the metal to be polished, the electrochemical properties of the surface to be polished, the dissociation state of functional groups of a compound, and the stability as a slurry.

The method of preparing the above-described metal polishing slurry of the invention is not subject to any particular limitation. For example, a method may be employed in which a reaction vessel is charged with at least one specific tetrazole compound of above formula (A), at least one triazole compound of above formula (B) or formula (C), water, the above-described oxidizer, and with the above-described various optional ingredients as required, following which the reactor contents are thoroughly stirred using a stirring apparatus such as a mixer. It is preferable to mix the above oxidizer into the metal polishing slurry of the invention at the time of use.

The substrate on which polishing is carried out using the inventive metal polishing slurry, and the polishing method are described below in detail.

Substrate (Wafer)

The substrate which is subjected to CMP using the metal polishing slurry of the invention has a diameter of preferably at least 200 mm. A diameter of at least 300 mm is more preferred as it enables the inventive slurry to exhibit a pronounced effect.

Wiring Metal Material

The metal to be polished using the metal polishing slurry of the invention is preferably copper and/or a copper alloy. That is, in the invention, the substrate which is subjected to polishing is preferably a substrate having interconnections formed with copper and/or a copper alloy, and more preferably a substrate having interconnections formed with a copper alloy.

Moreover, the copper alloy is preferably one containing silver. The silver content of the copper alloy is preferably 40 wt% or less, more preferably 10 wt% or less, even more preferably 1 wt% or less, and most preferably from 0.00001 to 0.1 wt%. Within this range, the effects of the metal polishing slurry of the invention can be fully exhibited.

Width of Interconnects

In the practice of the invention, the substrate subjected to polishing has a half-pitch linewidth of, in DRAM devices, for example, preferably not more than 0.15 pm, more preferably not more than 0.10 μm, and even more preferably not more than 0.08 μm. In microprocessing unit (MPU) devices, the half-pitch linewidth is preferably not more than 0.12 pm, more preferably not more than 0.09 pm, and even more preferably not more than 0.07 μm. The metal polishing slurry of the invention exhibits particularly outstanding effects on these LSI devices.

Barrier Metal

In the present invention, it is preferable that the substrate subjected to polishing has a barrier layer which is so located between the interconnections formed with copper and/or a copper alloy and an interlayer dielectric that it may prevent the diffusion of copper. It is desirable for the barrier layer to be made of a low-resistance metal material. Titanium nitride (TiN), titanium-tungsten (TiW), tantalum, tantalum nitride (TaN), tungsten, and tungsten nitride (WN) are preferred. Of these, tantalum and TaN are more preferred.

Polishing Method (Chemical Mechanical Polishing (CMP))

A polishing method which uses the metal polishing slurry of the invention is described below by way of illustration, although the slurry of the invention is usable to other polishing methods.

The metal polishing slurry of the invention may be prepared as a concentrate which is diluted at the time of use by adding water or an aqueous solution to form a working slurry; or prepared by furnishing various ingredients in the form of the aqueous solutions described later, mixing the solutions and diluting the mixture with water as needed to thereby form a working slurry; or again, prepared as a working slurry itself which contains the components specified in appended claim 1.

The polishing method which uses the metal polishing slurry of the invention is not subjected to any particular limitation, and is capable of using any of the above three types of slurries. The polishing method is specifically a method which involves feeding the polishing slurry to the polishing pad on the platen so as to bring the slurry into contact with the surface to be polished, and carrying out polishing by moving the surface to be polished and the polishing pad relatively to each other.

An ordinary polisher having a holder which holds the semiconductor integrated circuit substrate or the like having a surface to be polished and a platen (provided with a motor whose number of revolution is variable or the like) onto which a polishing pad is attached may be used as the apparatus employed for polishing.

The polishing pad is not subject to any particular limitation, and may be made of, for example, a common nonwoven fabric, expanded polyurethane, or porous fluorocarbon resin.

No particular limitation is imposed on the polishing conditions, although to keep the substrate from flying off the platen, it is preferable for the rotation speed of the platen to be 200 rpm or less. The pressure with which the semiconductor integrated circuit substrate having the surface to be polished (film to be polished) is pressed against the polishing pad is preferably from 5 to 500 g/cm$^2$. To achieve satisfactory uniformity of the polishing rate across the wafer and adequate pattern planarity, a pressure of 12 to 240 g/cm$^2$ is more preferred.

During polishing, it is preferable to continuously supply the metal polishing slurry of the invention by means of a pump or the like to the polishing pad. The amount of the polishing slurry supplied, while not subject to any particular limitation, is preferably such that the surface of the polishing pad is constantly covered with the slurry. To achieve satisfactory uniformity of the polishing rate across the wafer and adequate pattern planarity, the rate at which the metal polishing slurry is fed, while not subject to any particular limitation, is preferably from 10 to 1,000 ml/min, and more preferably from 170 to 800 ml/min.

After polishing is complete, the semiconductor integrated circuit substrate is thoroughly washed with running water, following which water drops adhering to the semiconductor integrated circuit substrate are dislodged using a spin dryer or the like, and the substrate is dried.

In the practice of the invention, when a concentrated slurry is diluted in such a way as described above with respect to the first type slurry, it is preferable to use an aqueous solution containing one or more selected from oxidizers, organic acids, additives and surfactant such that the resulting slurry contains the components specified in appended claim 1. The ingredients in the metal polishing slurry that is used during polishing, namely working slurry, are understood to be the ingredients contained in the foregoing aqueous solution added to those contained in the concentrated slurry to be diluted wherein the resulting working slurry must be in accordance with appended claim 1.

When a concentrated slurry is used after dilution with an aqueous solution in this way, difficult-to-dissolve ingredients can be blended in later in the form of an aqueous solution, which makes it possible to prepare a slurry that is more highly concentrated.

Methods for diluting a concentrated slurry with water or an aqueous solution include a method in which a line that feeds a concentrated metal polishing slurry and a line that feeds water or an aqueous solution are joined together at some intermediate point so that the respective fluids may be mixed, with the resulting metal polishing slurry dilution being fed to the polishing pad as a working slurry. Mixing of the concentrate and the water or aqueous solution may be carried out, for example, by a method that involves causing the two fluids to run under pressure through narrow passages so that the fluids may collide and mix with each other; a method in which a material such as glass tubing is packed in a pipe so as to make the flow of liquid split and confluent repeatedly; or a method that provides blades within a pipe which are powered to rotate.

One example of a method in which polishing is carried out while a concentrated-slurry is diluted with water or an aqueous solution is a process which independently provides a line that feeds a metal polishing slurry and a line that feeds water or an aqueous solution, feeds predetermined amounts of fluid from each line to the polishing pad, and carries out mixing of the two fluids and polishing at a time by moving the polishing pad and the surface to be polished relatively to each other. In another process which may be used, predetermined amounts of concentrated metal polishing slurry and of water or an aqueous solution are added to a single vessel and mixed, and the slurry after such mixing is fed to the polishing pad to carry out polishing.

In another polishing method, the ingredients to be contained in the metal polishing slurry are separated into at

least two components. At the time of their use, the two or more components are diluted with water or an aqueous solution, fed to the polishing pad on the platen and brought into contact with the surface to be polished, and polishing is carried out by moving the surface to be polished and the polishing pad relatively to each other.

For example, the oxidizer may be component (I), and at least one specific tetrazole compound of above formula (A), at least one triazole compound of above formula (B) or formula (C), an additive and water may constitute component (II), with such components (I) and (II) being diluted at the time of use with water or an aqueous solution wherein the resulting working slurry must be in accordance with appended claim 1.

Alternatively, additives having a low solubility may be distributed between components (I) and (II), whereupon component (I) comprises, for instance, the oxidizer, an additive and a surfactant while component (II) comprises at least one specific tetrazole compound of above formula (A), at least one triazole compound of above formula (B) or formula (C), an organic acid, an additive and water, with such components (I) and (II) being diluted at the time of use with water or an aqueous solution wherein the resulting working slurry must be in accordance with appended claim 1.

In the above examples, three lines are required to separately feed component (I), component (II), and the water or aqueous solution. Mixing for dilution may be carried out by a method in which the three lines are coupled to a single line for feeding to the polishing pad so that mixing is realized in the latter line. In this case, an alternative possibility is to join together two of the three lines, then later join the third line. In this method, the component containing difficult-to-dissolve additives and the other component are initially mixed in a long passage so as to ensure a sufficient dissolution time, following which water or an aqueous solution is added from its feeding line joined downstream of the mixing passage.

Other exemplary mixing methods include, similar to the above, a method where the three lines are each directly brought to the polishing pad and mixing is achieved by the movement of the polishing pad and the surface to be polished relative to each other, and a method where the three constituents as above are mixed in a single vessel, from which the diluted metal polishing slurry (working slurry) is fed to the polishing pad.

In the above-described polishing method, it is possible to set the component comprising the oxidizer to a temperature of 40°C or below while warming the other components to a temperature in a range from room temperature to 100°C, and adjust the liquid temperature to 40°C or below when the first component is mixed with the other components or when water or an aqueous solution is added to effect dilution. This method makes use of the increase in solubility at a higher temperature, and is advantageous in order to increase the solubility of low-solubility materials for the metal polishing slurry.

Because the materials which have been dissolved by warming the other components above to a temperature in a range from room temperature to 100°C precipitate out of solution when the temperature falls, in cases where the other components are in a low-temperature state at the time of use, the precipitated materials must be dissolved by pre-warming the components. This can be done by employing a means which warms the other components, then delivers the components in which the materials have been dissolved, or a means which agitates then delivers each of the precipitate-containing liquids, and warms the line for feeding the relevant component to effect dissolution. If the temperature of the oxidizer-comprising component is made higher than 40°C, there is a risk that the oxidizer will decompose. Hence, when the other components which have been warmed and the oxidizer-comprising component are mixed, it is preferable to have the temperature of the mixture be no higher than 40°C.

As described above, in the practice of the invention, the metal polishing slurry ingredients may be divided into two or more components to be fed to the polishing surface separately. In such a case, it is preferable to divide the ingredients into an oxidizer-comprising component and an organic acid-comprising component. It is also possible to prepare the metal polishing slurry as a concentrate and feed it to the polishing surface separately from the diluting water.

For all these different mixing schemes, it is necessary that the resulting working slurry is in accordance with the appended claim 1.

Polishing Pad

The polishing pad may be a pad having an unexpanded structure or a pad having an expanded structure. In pads having an unexpanded structure, a hard synthetic resin bulk material such as a plastic plate is used as the pad. There are three general types of pads having an expanded structure: those made of closed-cell foam (dry expanded), those made of open-cell foam (wet expanded), and those made of two-layer composites (laminated). Of these, pads made of two-layer composites (laminated) are especially preferred. Expansion may be uniform or non-uniform.

Moreover, the polishing pad may contain the abrasive used in polishing (e.g., ceria, silica, alumina, resin).

The polishing pad may be of a soft or hard nature. In a laminated polishing pad, it is preferable to have the layers made of materials of different hardnesses.

Preferred materials for the polishing pad include nonwoven fabric, synthetic leather, polyamide, polyurethane, polyester and polycarbonate.

The surface of the polishing pad which comes into contact with the surface to be polished may be shaped so as to form thereon, for example, grooves arranged as a grid, holes, concentric grooves, or spiral grooves.

As described above, the metal polishing slurry of the invention has a high polishing rate and good copper/tantalum polishing selectivity. When CMP is carried out using the inventive metal polishing slurry, little dishing occurs and the planarity of the substrate can be enhanced, thereby making it possible to minimize the occurrence of defects such as corrosion, scratching, thinning and erosion associated with local nonuniformities in polishing.

EXAMPLES

Examples are given below by way of illustration and should not be construed as limiting the invention as defined by the appended claims.

1. Preparation of Aluminum-Coated Colloidal Silica

Sodium hydroxide was added to 100 g of a 20 wt% aqueous dispersion of colloidal silica abrasive having an average particle size of 50 nm so as to adjust the pH to 9.5, following which 0.12 mmol of sodium aluminate was added at room temperature and the resulting mixture was stirred for 3 hours.

Assuming 100% reaction by the sodium aluminate added, the amount of silicon atoms on the surface of the colloidal silica that are substituted with aluminum atoms is 1% as represented as the colloidal silica surface atom substitution ratio (number of aluminum atoms introduced/number of surface silicon atom sites), based on the surface area calculated from the colloidal silica diameter, a specific gravity for colloidal silica of 2.2 and a number of silicon atoms per unit surface area of $13/nm^2$.

Abrasive particles which were not coated with aluminum (namely, the above colloidal silica abrasive particles, although untreated) are referred to below as "T-1", and abrasive particles which were coated with aluminum are referred to as "T-2."

2. Preparation of Metal Polishing Slurry

The ingredients shown in Table 1 were mixed using a stirrer so as to prepare metal polishing slurries for examples of the invention and comparative examples.

3. Evaluation of Metal Polishing Slurry

The polishing rate was evaluated by the following method.

Using the LGP-612 polishing system manufactured by Lapmaster SFT Corporation, metal films provided on wafers were polished while feeding individually the metal polishing slurries in Table 1 under the conditions indicated below, and the polishing rates at that time were calculated.

Substrate: 8-inch silicon wafer with copper film
Table speed: 64 rpm; Head speed: 65 rpm
(linear working velocity = 1.0 m/s)
Polishing pressure: 140 hPa
Polishing pad: Rohm and Haas product No. IC-1400 (K-grv) + (A21)
Slurry feed rate: 200 ml/min

For each metal polishing slurry, a copper blanket wafer, namely, a wafer (200 mm) having a 1.4 μm thick copper film formed thereon, was polished, and the thickness of the copper film at 49 places on the copper blanket wafer surface, both before and after CMP, was calculated from electrical resistance values. Based on the thickness values thus found, the average polishing rate (nm/min) for copper was determined.

The film thickness was calculated from electrical resistances before and after polishing. The following equation was used to determine the polishing rate.

Polishing rate (nm/min) = [(thickness of copper film before polishing) - (thickness of copper film after polishing)]/polishing time

Dishing was evaluated by the following method.

Using SEMATECH 854 patterned wafers as the test wafers, dishing was measured with a step height analyzer after 30% overpolishing based on the above-mentioned polishing rate. To be more specific: The time required to remove 1,300 nm by polishing when the plating thickness is 1,000 nm was calculated, and polishing was carried out for the

calculated time in the same way as for the copper film with no pattern, following which the step height in areas having a line/space ratio of 100 μm/100 μm was determined by measurement with a stylus-type step height analyzer.

The results are shown in Table 2.

Table 1

| Slurry No. | Type of abrasive | Formula (A) compound | Formula (B) or (C) compound | Other additives and amounts thereof |
|---|---|---|---|---|
| S-1 * | T-1 | A-4 | B-1 | citric acid: 1 g/L |
| S-2 * | T-1 | A-3 | B-1 | " |
| S-3 * | T-1 | A-1 | B-1 | " |
| S-4 * | T-1 | A-1 | B-1 | dihydroxyethylglycine: 1 g/L |
| S-5 | T-2 | A-1 | B-1 | " |
| S-6 | T-2 | A-3 | B-1 | " |
| S-7 | T-2 | A-3 | C-1 | " |
| S-8 | T-2 | A-3 | C-5 | " |
| S-9 | T-2 | A-11 | C-5 | " |
| S-10 | T-2 | A-1 | B-1 | dihydroxyethylglycine: 1 g/L, dodecylbenzenesulfonic acid: 0.1 g/L |
| S-11 | T-2 | A-1 | B-1 | dihydroxyethylglycine: 1 g/L, dodecylbenzenesulfonic acid: 0.1 g/L tetramethylammonium hydroxide: 0.1 g/L |
| S-12* | T-1 | A-1 | - | citric acid: 1 g/L |
| S-13* | T-1 | - | B-1 | " |
| *Comparative example | | | | |

All the metal polishing slurries were adjusted to a pH of 6.5. Adjustment was carried out using ammonia and nitric acid.

Each slurry had 30% hydrogen peroxide added thereto in an amount of 25 mL per liter of the relevant slurry.

Each slurry had an abrasive concentration of 0.25 wt%.

The compound of formula (A) was added in an amount of 0.003 wt%, and the compound of formula (B) or (C) was added in an amount of 0.002 wt%.

Table 2

| Slurry No. | Polishing rate (nm/min) | Dishing (nm) | Remarks |
|---|---|---|---|
| S-1 | 620 | 72 | comparative example |
| S-2 | 591 | 69 | comparative example |
| S-3 | 580 | 79 | comparative example |
| S-4 | 556 | 64 | comparative example |
| S-5 | 539 | 56 | example of the invention |
| S-6 | 503 | 50 | " |
| S-7 | 486 | 56 | " |
| S-8 | 547 | 62 | " |
| S-9 | 509 | 57 | " |
| S-10 | 478 | 46 | " |
| S-11 | 496 | 49 | " |

(continued)

| Slurry No. | Polishing rate (nm/min) | Dishing (nm) | Remarks |
|---|---|---|---|
| S-12 | 537 | 126 | comparative example |
| S-13 | 559 | 139 | " |

## Claims

1. A metal polishing slurry for use in chemical mechanical metal polishing during semiconductor device fabrication, comprising at least one compound of formula (A) below and at least one compound of formula (B) or formula (C) below:

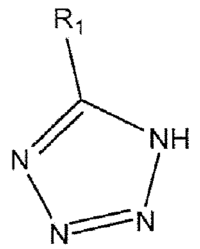

(A)

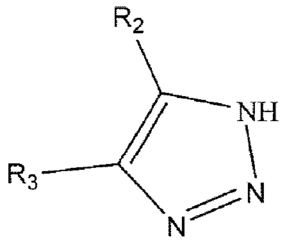

(B)

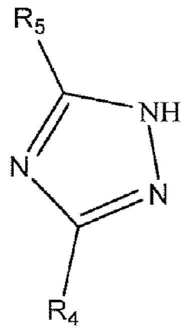

(C)

wherein $R_1$, $R_2$, $R_3$, $R_4$ and $R_5$ are each independently hydrogen, methyl, ethyl, phenyl, amino, sulfo, carboxy, aminomethyl, carboxymethyl, sulfomethyl, o-aminophenyl, m-aminophenyl, p-aminophenyl, o-carboxyphenyl, m-carboxyphenyl, p-carboxyphenyl, o-sulfophenyl, m-sulfophenyl or p-sulfophenyl,
which further comprises colloidal silica, wherein at least some of silicon atoms at the surface of the colloidal silica are substituted with aluminum atoms, and which further contains an oxidizer and water.

2. The metal polishing slurry according to claim 1, wherein said colloidal silica has a primary particle size of 10 to 60 nm.

3. The metal polishing slurry according to any one of claims 1 to 2 which has a pH of 2 to 7.

4. The metal polishing slurry according to any one of claims 1 to 3 which has a colloidal silica concentration of 0.001 to 0.5 wt%.

5. The metal polishing slurry according to any one of claims 1 to 4 which further comprises a compound having at least one carboxy group and at least one amino group in its molecule.

6. The metal polishing slurry according to claim 5, wherein at least one amino group in said compound having at least one carboxy group and at least one amino group is a secondary or tertiary amino group.

7. The metal polishing slurry according to any one of claims 1 to 6 which further comprises a quaternary alkylammonium compound.

8. Use of the metal polishing slurry according to any one of claims 1 to 7 for chemical mechanical metal polishing in semiconductor integrated circuit substrate manufacturing.

**Patentansprüche**

1. Metallpolieraufschlämmung zur Verwendung beim chemischmechanischen Metallpolieren während der Herstellung von Halbleitervorrichtungen, umfassend zumindest eine Verbindung der nachstehenden Formel (A) und zumindest eine Verbindung der nachstehenden Formel (B) oder Formel (C):

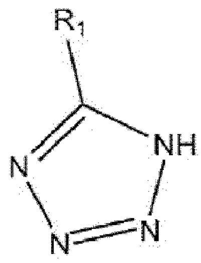

(A)

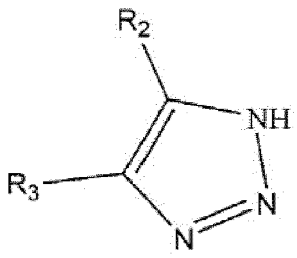

(B)

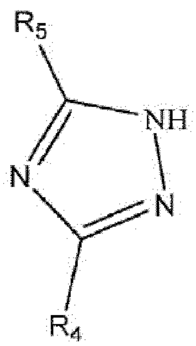

(C)

worin $R_1$, $R_2$, $R_3$, $R_4$ und $R_5$ jeweils unabhängig Wasserstoff, Methyl, Ethyl, Phenyl, Amino, Sulfo, Carboxy, Aminomethyl, Carboxymethyl, Sulfomethyl, o-Aminophenyl, m-Aminophenyl, p-Aminophenyl, o-Carboxyphenyl, m-Carboxyphenyl, p-Carboxyphenyl, o-Sulfophenyl, m-Sulfophenyl oder p-Sulfophenyl sind,
die ferner kolloidales Siliciumdioxid umfasst, wobei zumindest einige der Siliciumatome an der Oberfläche des kolloidalen Siliciumdioxids mit Aluminiumatomen substituiert sind, und die ferner ein Oxidationsmittel und Wasser enthält.

2. Metallpolieraufschlämmung gemäss Anspruch 1, wobei das kolloidale Siliciumdioxid eine primäre Partikelgrösse

von 10 bis 60 nm aufweist.

3. Metallpolieraufschlämmung gemäss irgendeinem der Ansprüche 1 bis 2, die einen pH-Wert von 2 bis 7 aufweist.

4. Metallpolieraufschlämmung gemäss irgendeinem der Ansprüche 1 bis 3, die eine Konzentration an kolloidalem Siliciumdioxid von 0,001 bis 0,5 Gew.% aufweist.

5. Metallpolieraufschlämmung gemäss irgendeinem der Ansprüche 1 bis 4, die ferner eine Verbindung umfasst, die zumindest eine Carboxygruppe und zumindest eine Aminogruppe in ihrem Molekül aufweist.

6. Metallpolieraufschlämmung gemäss Anspruch 5, wobei zumindest eine Aminogruppe in der Verbindung, die zumindest eine Carboxygruppe und zumindest eine Aminogruppe aufweist, eine sekundäre oder tertiäre Aminogruppe ist.

7. Metallpolieraufschlämmung gemäss irgendeinem der Ansprüche 1 bis 6, die ferner eine quaternäre Alkylammoniumverbindung umfasst.

8. Verwendung der Metallpolieraufschlämmung gemäss irgendeinem der Ansprüche 1 bis 7 zum chemischmechanischen Metallpolieren bei der Herstellung eines integrierten Halbleiterschaltkreissubstrats.

**Revendications**

1. Suspension de polissage pour métal destinée à être utilisée dans le polissage de métal chimico-mécanique lors de la fabrication d'un dispositif semi-conducteur, comprenant au moins un composé de formule (A) ci-après et un composé de formule (B) ou de formule (C) ci-après :

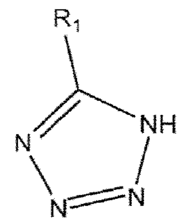

(A)

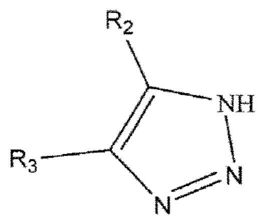

(B)

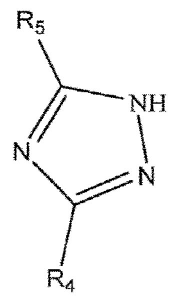

(C)

dans laquelle $R_1$, $R_2$, $R_3$, $R_4$ et $R_5$ sont chacun indépendamment un atome d'hydrogène, un groupe méthyle, éthyle, phényle, amino, sulfo, carboxy, aminométhyle, carboxyméthyle, sulfométhyle, o-aminophényle, m-aminophényle, p-aminophényle, o-carboxyphényle, m-carboxyphényle, p-carboxyphényle, o-sulfophényle, m-sulfophényle ou p-sulfophényle,
qui comprend en outre de la silice colloïdale, dans laquelle au moins certains des atomes de silicium à la surface de la silice colloïdale sont substitués par des atomes d'aluminium, et qui contient en outre un oxydant et de l'eau.

**2.** Suspension de polissage pour métal selon la revendication 1, dans laquelle ladite silice colloïdale a une taille de particule primaire de 10 à 60 nm.

**3.** Suspension de polissage pour métal selon l'une quelconque des revendications 1 à 2 qui a un pH de 2 à 7.

**4.** Suspension de polissage pour métal selon l'une quelconque des revendications 1 à 3 qui a une concentration en silice colloïdale de 0,001 à 0,5 % en poids.

**5.** Suspension de polissage pour métal selon l'une quelconque des revendications 1 à 4 qui comprend en outre un composé ayant au moins un groupe carboxy et au moins un groupe amino dans sa molécule.

**6.** Suspension de polissage pour métal selon la revendication 5, dans laquelle au moins un groupe amino dans ledit composé ayant au moins un groupe carboxy et au moins un groupe amino est un groupe amino secondaire ou tertiaire.

**7.** Suspension de polissage pour métal selon l'une quelconque des revendications 1 à 6 qui comprend en outre un composé d'alkylammonium quaternaire.

**8.** Utilisation de la suspension de polissage pour métal selon l'une quelconque des revendications 1 à 7 pour polissage de métal chimico-mécanique dans la fabrication de substrat de circuit intégré à semi-conducteur.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 4944836 A
- JP 2278822 A
- EP 1612249 A
- EP 1548075 A
- US 2002020833 A
- JP 49122432 A
- JP 3463328 B
- JP 63123807 A
- JP 2005159269 A
- US 3007878 A
- JP 2003197573 A